# EUROPEAN PATENT APPLICATION

(11) **EP 4 832 295 A1**
(43) Date of publication of application: **28.10.2026**
(21) Application number: 24914873.5
(22) Date of filing: 04.09.2024
(51) Int. Cl.: H02J 7/00

(54) **HIGH-VOLTAGE BOX, BATTERY AND ELECTRICAL DEVICE**

(30) Priority: 02.01.2024 CN 202420016694 U
(71) Applicant: Contemporary Amperex Technology Co., Limited, Ningde, Fujian 352100 (CN)
(72) Inventor: QIU, Guanda, Ningde, Fujian 352100 (CN); LI, Yuanxin, Ningde, Fujian 352100 (CN); WANG, Chong, Ningde, Fujian 352100 (CN); ZHENG, Chenling, Ningde, Fujian 352100 (CN); CHEN, Yibo, Ningde, Fujian 352100 (CN)
(74) Representative: Ziebig Hengelhaupt Intellectual Property Attorneys Patentanwaltskanzlei PartGmbB
(86) International application number: PCT/CN2024/116868
(87) International publication number: WO 2025/145651

(57) **Abstract**

Provided in the present application are a high-voltage box (400), a battery (100) and an electrical device. The high-voltage box (400) comprises a box body (410) connected to a case body (10), an accommodation cavity (4101) being formed in the box body (410), and the box body (410) being provided with a through hole (411) communicated with the accommodation cavity (4101). The high-voltage box (400) provided in the embodiments of the present application enables an electrical connection structure (30) of the battery (100) to be inserted into the through hole (411) and to extend into the accommodation cavity (4101), such that the electrical connection structure (30) and an electrical component (420) in the box body (410) can be directly and electrically connected, which, compared with the manner of mating connection of a male terminal and a female terminal of a connector, can effectively reduce the probability of connection failure.

## Description

This application refers to the Chinese Patent Application No. 202420016694.7, filed on January 2, 2024 and entitled "HIGH-VOLTAGE BOX, BATTERY, AND ELECTRIC DEVICE", which is incorporated herein by reference in its entirety.

### TECHNICAL FIELD

This application relates to the technical field of high-voltage boxes, and particularly provides a high-voltage box, a battery, and an electric device.

### BACKGROUND

A high-voltage box is mainly used for centralized control and protection of high-voltage power systems to ensure the safe and stable operation of the power system. In electric apparatuses such as vehicles driven by electricity or hybrid power, the high-voltage box is a control unit for distributing the energy of the traction battery and is used for high-voltage distribution of the traction battery.

In the related technology, a high-voltage box and a battery are electrically connected by mating a male connector with a female connector of a connector assembly, and the connector assembly is prone to failure of the connection interface, thereby leading to failure of the connection between the high-voltage box and the battery.

### SUMMARY

Embodiments of this application are intended to provide a high-voltage box, a battery, and an electric device, aiming to solve the problem in the related technology that a plug-in connection between a high-voltage box and a battery via a male connector and a female connector of a connector assembly is prone to failure of the connection interface.

To achieve the above purpose, the technical solution adopted in the embodiments of this application is as follows:

According to a first aspect, embodiments of this application provide a high-voltage box provided on a case of a battery. The high-voltage box includes a box body, and the box body is connected to the case. An accommodation cavity for accommodating electrical components is formed inside the box body. The box body is provided with a through hole communicating with the accommodation cavity, and the through hole is used for insertion of an electrical connection structure of the battery.

The beneficial effects of the embodiments of this application are as follows: The embodiments of this application provide the high-voltage box, the high-voltage box has a box body that can be connected to the case of the battery, and a through hole can be provided in the box body, so that the electrical connection structure of the battery can be inserted into the through hole and extend into the accommodation cavity, and the electrical connection structure can be directly electrically connected to the electrical components inside the box body of the high-voltage box. Thereby, the electrical connection structure of the battery directly extends into the box body and is electrically connected to the internal electrical components. This can effectively reduce the probability of connection failure, compared with the connection method of mating a male connector with a female connector of a connector assembly. At the same time, since the use of the connector assembly is reduced, the overall cost of the high-voltage box can be effectively reduced, and the assembly efficiency and maintenance efficiency of the high-voltage box can be improved.

In some embodiments, the box body has a mounting side surface, the mounting side surface faces the case, and the through hole is provided in the mounting side surface.

With adoption of the above technical solution, the through hole can be provided in the mounting side surface facing a side of the case, and the electrical connection structure of the battery can be directly inserted into the through hole, which can effectively reduce the wiring distance of the electrical connection structure and improve the assembly efficiency of the high-voltage box.

In some embodiments, at least part of the mounting side surface abuts against a wall surface of the case, and the through hole is provided in the part of the mounting side surface that abuts against the wall surface of the case.

With adoption of the above technical solution, the through hole can be provided in the part of the mounting side surface that abuts against the wall surface of the case, so that the wall surface of the case can form a sealing cover for the through hole to improve the sealing inside the box body, and at the same time, the distance between the through hole and the case can be reduced to reduce the material used for the electrical connection structure, thereby achieving the purpose of reducing costs.

In some embodiments, the high-voltage box further includes a sealing structure, and the sealing structure is provided on the box body and configured to seal the through hole.

With adoption of the above technical solution, by providing the sealing structure on the box body to achieve sealing protection at the through hole, the sealing of the accommodation cavity can be improved.

In some embodiments, the sealing structure includes a sealing ring, the sealing ring is clamped between the mounting side surface and the case, and the sealing ring is annularly provided around an orifice end of the through hole.

With adoption of the above technical solution, by providing the sealing ring between the mounting side surface and the case, when the box body is mounted on the case, the sealing ring is clamped between the mounting side surface and the case, so that the sealing ring and the case can provide sealing protection for the through hole, effectively improving the sealing of the accommodation cavity.

In some embodiments, the sealing ring includes a main body portion and a protruding portion, the main body portion is clamped between the mounting side surface and the case, the main body portion is annularly provided around the through hole, the protruding portion is connected to the main body portion, and the protruding portion is inserted into the through hole.

With adoption of the above technical solution, the main body portion of the sealing ring is provided between the mounting side surface and the case to achieve sealing protection for the through hole, and at the same time, the protruding portion of the sealing ring is inserted into the through hole, so that when the electrical connection structure is inserted, the protruding portion is located between the electrical connection structure and a hole inner wall of the through hole, and the protruding portion can protect the electrical connection structure and reduce the probability that the insulation sleeve on the electrical connection structure is worn by the orifice end or the hole inner wall of the through hole.

In some embodiments, the protruding portion is annular, and the protruding portion is located between the electrical connection structure and the hole inner wall of the through hole.

With adoption of the above technical solution, the annular protruding portion extends into the through hole, so that when the electrical connection structure is inserted into the through hole, the electrical connection structure can pass through the center of the annular protruding portion, and the protruding portion can protect the entire circumferential side of the hole inner wall of the through hole, further reducing the probability that the insulation sleeve on the electrical connection structure is worn by the hole inner wall.

In some embodiments, the protruding portion passes through the through hole and extends into the accommodation cavity.

With adoption of the above technical solution, since the protruding portion extends into the accommodation cavity, the protruding portion can also cover and protect the orifice end of the through hole on the side of the accommodation cavity, thereby reducing the probability that the insulation sleeve on the electrical connection structure is worn or scratched by the orifice end on the side of the accommodation cavity.

In some embodiments, the mounting side surface and the hole inner wall of the through hole are connected through a first chamfered surface.

With adoption of the above technical solution, connecting the mounting side surface and the hole inner wall of the through hole through the first chamfered surface can reduce the probability of scratching the insulation sleeve on the electrical connection structure due to the formation of an edge between the mounting side surface and the hole inner wall of the through hole.

In some embodiments, an inner side wall surface of the accommodation cavity and the hole inner wall of the through hole are connected through a second chamfered surface.

With adoption of the above technical solution, connecting the inner side wall surface of the accommodation cavity and the hole inner wall of the through hole through the first chamfered surface can reduce the probability of scratching the insulation sleeve on the electrical connection structure due to the formation of an edge between the inner side wall surface of the accommodation cavity and the hole inner wall of the through hole.

In some embodiments, a mounting portion is provided on the box body, and the mounting portion is connected to the case.

With adoption of the above technical solution, the box body can be connected and assembled with the case through the mounting portion to improve the assembly efficiency.

In some embodiments, the mounting portion has a connection surface facing the case, and the connection surface is flush with the mounting side surface.

With adoption of the above technical solution, the connection surface of the mounting portion is flush with the mounting side surface, so that when the mounting portion is mounted on the case, the mounting side surface can synchronously abut against the surface mounted on the case to ensure the abutting fit of the mounting side surface to the case, thereby improving the sealing protection effect of the sealing ring on the through hole.

In some embodiments, the box body includes a housing and an upper cover, the housing forms the accommodation cavity with an opening, and the upper cover is connected to the housing and covers the opening; and the mounting portion is provided on the housing, and the through hole is provided in the housing.

With adoption of the above technical solution, the housing forms the accommodation cavity to accommodate the electrical components, and the upper cover can cover the opening of the housing to seal the accommodation cavity. At the same time, the through hole is provided in the housing, and the mounting portion is also located on the housing, so that the housing can be connected to the case through the mounting portion, and the electrical connection structure can extend into the accommodation cavity through the through hole provided in the housing to achieve electrical connection. When maintenance of the high-voltage box is required, the upper cover can be opened to expose the electrical components inside the accommodation cavity without disassembling and assembling the housing, effectively improving the convenience of maintenance.

In some embodiments, a connection bracket is provided in the accommodation cavity, and the connection bracket is configured to fixedly connect the electrical connection structure and a conductive structure of the electrical components.

With adoption of the above technical solution, by providing the connection bracket in the accommodation cavity, the electrical connection structure of the battery and the conductive structure of the electrical components can be fixed on the connection bracket and achieve a contact connection, and the electrical connection is achieved through the fixing and contact connection method, effectively improving the stability and reliability of the electrical connection.

In some embodiments, the number of through holes is one or two.

With adoption of the above technical solution, the number of through holes can be one, the electrical connection structure includes a positive electrode copper bar and a negative electrode copper bar, and both the positive electrode copper bar and the negative electrode copper bar can be inserted and connected through the through hole; or, the number of through holes can be two, so that the positive electrode copper bar and the negative electrode copper bar can be inserted and connected through different through holes.

According to a second aspect, embodiments of this application further provide a battery including a case, battery cells, an electrical connection structure, and the high-voltage box as described above. The battery cells are accommodated in the case, the box body of the high-voltage box is provided on an outer surface of the case, the electrical connection structure is electrically connected to the battery cells, and the electrical connection structure passes through the through hole and is electrically connected to the electrical components in the accommodation cavity.

The beneficial effects of the embodiments of this application are as follows: The battery provided in the embodiments of this application includes the above high-voltage box. Since the box body of the high-voltage box is provided with a through hole, the electrical connection structure of the battery can pass through the through hole and extend into the accommodation cavity, so that the electrical connection structure can be directly connected to the electrical components in the accommodation cavity, which can effectively reduce the probability of connection failure of the high-voltage box, thereby effectively improving the stability and reliability of the battery.

According to a third aspect, embodiments of this application further provide an electric device including the battery as described above, where the battery is configured to provide electrical energy.

The beneficial effects of the embodiments of this application are as follows: The electric device provided in the embodiments of this application includes the above battery, and on the basis that the above battery has good stability and reliability, the electric device also has good stability and reliability.

### BRIEF DESCRIPTION OF DRAWINGS

In order to more clearly illustrate the technical solutions in the embodiments of this application, the drawings to be used in the description of the embodiments or the related technology will be briefly introduced below. Obviously, the drawings described below are only some embodiments of this application. For those of ordinary skill in the art, other drawings can also be obtained based on these drawings without creative effort.
FIG. 1 is a schematic structural diagram of a vehicle according to an embodiment of this application;
FIG. 2 is an exploded view of a battery according to an embodiment of this application;
FIG. 3 is a schematic structural diagram of a high-voltage box according to an embodiment of this application;
FIG. 4 is an exploded view of a high-voltage box according to an embodiment of this application;
FIG. 5 is a schematic structural diagram of a sealing ring according to an embodiment of this application;
FIG. 6 is a schematic structural diagram of another sealing ring according to an embodiment of this application; and
FIG. 7 is a schematic structural diagram of a housing according to an embodiment of this application.

In the drawings, the reference signs in the drawings are as follows:
1000. vehicle;
100. battery; 200. controller; 300. motor;
10. case; 11. first portion; 12. second portion; 20. battery cell; 30. electrical connection structure; 31. positive electrode copper bar; 32. negative electrode copper bar;
400. high-voltage box;
410. box body; 4101. accommodation cavity; 4102. mounting side surface; 411. through hole; 412. first chamfered surface; 413. mounting portion; 4131. connection surface; 414. housing; 415. upper cover; 4151. opening;
420. electrical component;
430. sealing structure; 431. sealing ring; 4311. main body portion; 4312. protruding portion; and
440. connection bracket.

### DESCRIPTION OF EMBODIMENTS

The embodiments of this application will be described in detail below, and examples of the embodiments are illustrated in the accompanying drawings, where like or similar reference numerals refer to like or similar elements or elements having the same or similar functions throughout. The embodiments described below with reference to the drawings are exemplary and are intended to explain this application and should not be construed as limiting this application.

In the description of this application, it should be understood that the orientations or positional relationships indicated by the terms "length", "width", "upper", "lower", "front", "rear", "left", "right", "vertical", "horizontal", "top", "bottom", "inner", "outer", and the like are based on the orientations or positional relationships shown in the drawings, which are only for the convenience of describing this application and simplifying the description, and do not indicate or imply that the means or element referred to must have a specific orientation, be constructed and operated in a specific orientation, and therefore should not be construed as limiting this application.

In addition, the terms "first" and "second" are used for descriptive purposes only and should not be construed as indicating or implying relative importance or implicitly indicating the number of technical features indicated. Thus, a feature defined as "first" or "second" may explicitly or implicitly include one or more such features. In the description of this application, the meaning of "multiple" is two or more unless specifically defined otherwise.

In this application, unless otherwise clearly specified and limited, the terms "mounting", "connecting", "join", "fixing", and the like should be understood in a broad sense. For example, they may be a fixed connection, a detachable connection, or an integral body; they may be a mechanical connection or an electrical connection; they may be a direct connection or an indirect connection through an intermediary; or they may be the internal communication of two elements or the interaction relationship between two elements. For those of ordinary skill in the art, the specific meanings of the above terms in this application can be understood according to specific situations.

At present, from the development of the market situation, the application of traction batteries is becoming more and more widespread. Traction batteries are not only used in energy storage power systems such as hydropower, thermal power, wind power, and solar power stations, but also widely used in electric bicycles, electric motorcycles, electric vehicles, and other electric vehicles, as well as military equipment, aerospace, and many other fields. With the continuous expansion of the application fields of traction batteries, the market demand is also continuously increasing.

Batteries are used in power systems to provide electrical energy, and batteries need to be controlled and protected through high-voltage boxes to ensure the safe and stable operation of the power system. In electric apparatuses such as vehicles driven by electricity or hybrid power, the high-voltage box is a control unit for distributing the energy of the traction battery and is used for high-voltage distribution of the traction battery. In the related technology, the high-voltage box and the battery are electrically connected by mating a male connector and a female connector of a connector assembly. However, the mating engagement structure of the male connector and the female connector of the connector assembly, when the connection interface of the male connector or the female connector fails, is likely to cause the connector assembly to fail, thereby causing failure of the connection between the high-voltage box and the battery cells inside the battery.

Based on the above considerations, in order to solve the problem in the related technology that a plug-in connection between a high-voltage box and a battery via a male connector and a female connector of a connector assembly is prone to failure of the connection interface, a high-voltage box is designed, where a through hole is provided in a box body of the high-voltage box, so that when the high-voltage box is connected, the electrical connection structure of the battery can pass through the through hole to the inside of the accommodation cavity, and the electrical connection structure is directly electrically connected to the electrical components in the accommodation cavity. This can reduce the use of connector assembly, thereby reducing the probability of connection failure of the high-voltage box caused by the failure of the connection interface of the connector assembly; at the same time, since the use of the connector assembly is reduced, the structure of the high-voltage box is simplified, thereby reducing the cost of the high-voltage box, and improving the assembly efficiency and maintenance efficiency of the high-voltage box.

The high-voltage box disclosed in the embodiments of this application can be externally mounted on the case of the battery to achieve assembly, and directly connected to the electrical connection structure of the battery through the through hole to achieve electrical connection with the battery.

The battery provided in the embodiments of this application can be used as a power source for electric devices or as an energy storage element for various energy storage systems. The electric device can be but is not limited to mobile phones, tablets, notebook computers, electric toys, electric tools, battery bicycles, electric vehicles, ships, and spacecraft. Electric toys can include fixed or mobile electric toys, such as game consoles, electric vehicle toys, electric ship toys, and electric aircraft toys, and spacecraft can include airplanes, rockets, space shuttles, spaceships, and the like.

For ease of description, the following embodiments are described by taking an electric device according to an embodiment of this application being a vehicle 1000 as an example.

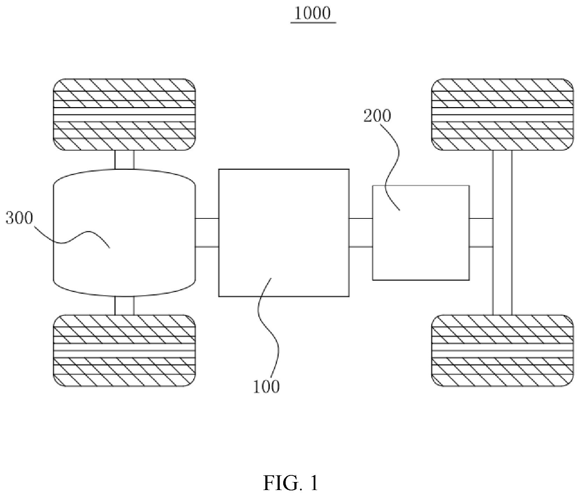

Referring to FIG. 1, FIG. 1 is a schematic structural diagram of a vehicle 1000 according to some embodiments of this application. The vehicle 1000 can be a fuel vehicle, a gas vehicle, or a new energy vehicle, and the new energy vehicle can be a pure electric vehicle, a hybrid electric vehicle, an extended-range vehicle, or the like. A battery 100 is provided inside the vehicle 1000, and the battery 100 can be provided at the bottom, head, or tail of the vehicle 1000. The battery 100 can be used for power supply of the vehicle 1000, for example, the battery 100 can serve as an operating power source for the vehicle 1000. The vehicle 1000 can also include a controller 200 and a motor 300, and the controller 200 is used to control the battery 100 to supply power to the motor 300, for example, for the starting, navigation, and driving power needs of the vehicle 1000.

In some embodiments of this application, the battery 100 can serve not only as an operating power source for the vehicle 1000, but also as a driving power source for the vehicle 1000, replacing or partially replacing fuel or natural gas to provide driving power for the vehicle 1000.

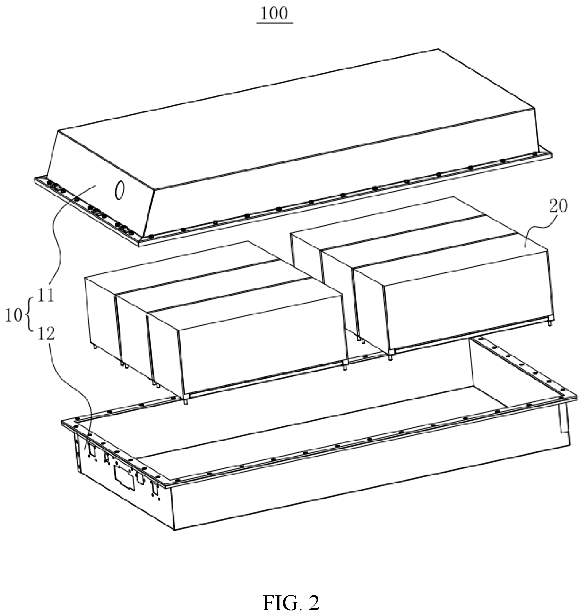

Referring to FIG. 2, FIG. 2 is an exploded view of a battery 100 according to some embodiments of this application. The battery 100 includes a case 10 and battery cells 20, and the battery cells 20 are accommodated in the case 10. The case 10 is configured to provide an accommodation space for the battery cells 20, and the case 10 can adopt multiple structures. In some embodiments, the case 10 can include a first portion 11 and a second portion 12, the first portion 11 and the second portion 12 fit with each other, and the first portion 11 and the second portion 12 together define an accommodation space for accommodating the battery cells 20. The second portion 12 can be a hollow structure with an opening at one end, the first portion 11 can be a plate-shaped structure, and the first portion 11 covers the opening side of the second portion 12, so that the first portion 11 and the second portion 12 together define the accommodation space. The first portion 11 and the second portion 12 can also both be hollow structures with an opening on one side, and the opening side of the first portion 11 fits with the opening side of the second portion 12. Certainly, the case 10 formed by the first portion 11 and the second portion 12 can be in various shapes, such as a cylinder or a cuboid.

In the battery 100, there can be multiple battery cells 20, and the multiple battery cells 20 can be connected in series, in parallel, or in a hybrid connection, where the hybrid connection means that there are both series and parallel connections among the multiple battery cells 20. The multiple battery cells 20 can be directly connected in series, in parallel, or in a hybrid connection, and then the whole formed by the multiple battery cells 20 is accommodated in the case 10. Certainly, the battery 100 can also be formed by first connecting multiple battery cells 20 in series, in parallel, or in a hybrid connection to form a battery module, connecting multiple battery modules in series, in parallel, or in a hybrid connection to form a whole, and accommodating the whole in the case 10. The battery 100 can also include other structures, for example, the battery 100 can also include a bus component for achieving electrical connection between multiple battery cells 20.

Each battery cell 20 can be a secondary battery or a primary battery; it can also be a lithium-sulfur battery, a sodium-ion battery, or a magnesium-ion battery, but is not limited thereto. The battery cell 20 can be in the shape of a cylinder, a flat body, a cuboid, or other shapes.

According to some embodiments of this application, referring to FIG. 2 to FIG. 4, according to a first aspect, embodiments of this application provide a high-voltage box 400 on the case 10 of the battery 100. The high-voltage box 400 includes a box body 410, and the box body 410 is connected to the case 10. An accommodation cavity 4101 for accommodating electrical components 420 is formed inside the box body 410. The box body 410 is provided with a through hole 411 communicating with the accommodation cavity 4101, and the through hole 411 is used for insertion of the electrical connection structure 30 of the battery 100.

An accommodation cavity 4101 is formed inside the box body 410 of the high-voltage box 400, and the accommodation cavity 4101 is used to accommodate the electrical components 420. The box body 410 can be, but is not limited to, a box body 410 of various configurations such as a rectangular box, a cylindrical box, or a spherical box. Optionally, the box body 410 can be a box body 410 made of various materials, such as an aluminum alloy box, a steel alloy box, an injection molded box, or a steel-aluminum composite box.

The box body 410 is connected to the case 10. Optionally, the box body 410 can be connected to the inner wall surface of the case 10, or the box body 410 can also be connected to the outer wall surface of the case 10 to achieve the purpose of being externally mounted on the case 10; the box body 410 can be fixed to the wall surface of the case 10 by fasteners (such as bolts or screws), or the box body 410 can also be adhesively fixed on the case 10, or the box body 410 can also be fixed on the case 10 by welding to achieve connection.

The through hole 411 is provided in the box body 410 for insertion of the electrical connection structure 30 of the battery 100, so that the electrical connection structure 30 of the battery 100 can directly extend into the accommodation cavity 4101 and achieve electrical connection with the internal electrical components 420.

It can be understood that the electrical connection structure 30 refers to a conductive structure of the battery 100 for transmitting electrical energy; the electrical connection structure 30 includes but is not limited to electrical connection bars (such as copper metal conductive bars, silver metal conductive bars, and other metal structures with good conductivity), conductive cables, conductive posts, and other conductive structures. It should be understood that the outer surface of the electrical connection structure 30 is sleeved with an insulation sleeve to achieve insulation protection. Exemplarily, in some specific embodiments, the electrical connection structure 30 can include connection copper bars, the connection copper bars include a positive electrode copper bar 31 and a negative electrode copper bar 32, both the positive electrode copper bar 31 and the negative electrode copper bar 32 are sleeved with thermoplastic sleeves to achieve insulation protection, and the positive electrode copper bar 31 and the negative electrode copper bar 32 are exposed outside the thermoplastic sleeve at the connection to achieve contact connection. The connection copper bars are provided on the case 10, for example, they can be mounted on the case 10 through an insulation mounting seat, and the connection copper bars extend out of the case 10 to achieve electrical connection with devices outside the case 10 (such as the high-voltage box 400 in this embodiment).

One end of the electrical connection structure 30 is electrically connected to the battery cells 20 inside the case 10, and the other end of the electrical connection structure 30 can be inserted into the through hole 411 and extend into the accommodation cavity 4101 to achieve the purpose of being electrically connected to the electrical components 420 in the accommodation cavity 4101. By adopting the structural design in which the electrical connection structure 30 is directly inserted into the accommodation cavity 4101 for direct connection, the use of connector assemblies can be reduced, thereby reducing costs and reducing the risk of connection failure of the high-voltage box 400 caused by the likely connection failure of the connection interface of the connector assembly.

The through hole 411 is used for insertion of the electrical connection structure 30; the through hole 411 can be, but is not limited to, a circular through hole, a polygonal through hole (such as a rectangular through hole or a hexagonal through hole), or any other shaped through hole.

Optionally, the through hole 411 can be provided in any side surface of the box body 410. Exemplarily, in some embodiments, the through hole 411 can be provided in a side wall surface of the box body 410 facing the case 10, and the electrical connection structure 30 of the battery 100 can face the box body 410 and directly extend to be inserted into the through hole 411. Alternatively, in other manners, the through hole 411 can be provided in any other wall surface other than the side wall surface of the box body 410 facing the case 10, for example, a side wall surface intersecting the wall surface of the box body 410 facing the case 10. The electrical connection structure 30 of the battery 100 needs to be bent and wired to the side wall surface where the through hole 411 is provided, and then correspondingly inserted into the through hole 411.

Optionally, the number of through holes 411 can be one, and the electrical connection structure 30 includes connection copper bars, so that the positive electrode copper bar 31 and the negative electrode copper bar 32 of the connection copper bars can both pass through the through hole 411; or, the number of through holes 411 can be two, and the electrical connection structure 30 includes connection copper bars, so that the positive electrode copper bar 31 and the negative electrode copper bar 32 of the connection copper bars can respectively pass through different through holes 411; or, the number of through holes 411 can also be more than two, so that any one or two through holes 411 that are opposite to or closer to the electrical connection structure 30 can be selected for passing through to improve assembly efficiency.

The embodiments of this application provide the high-voltage box 400, the high-voltage box 400 has a box body 410 that can be connected to the case 10 of the battery 100, and a through hole 411 can be provided in the box body 410, so that the electrical connection structure 30 of the battery 100 can be inserted into the through hole 411 and extend into the accommodation cavity 4101, and the electrical connection structure 30 can be directly electrically connected to the electrical components 420 inside the box body of the high-voltage box 400. Thereby, the electrical connection structure 30 of the battery 100 directly extends into the box body 410 and is electrically connected to the internal electrical components 420. This can effectively reduce the probability of connection failure, compared with the connection method of mating a male connector with a female connector of a connector assembly. At the same time, since the use of the connector assembly is reduced, the overall cost of the high-voltage box 400 can be effectively reduced, and the assembly efficiency and maintenance efficiency of the high-voltage box 400 can be improved.

It can be understood that the electrical components 420 accommodated in the accommodation cavity 4101 include but are not limited to resistors, positive electrode relays, negative electrode relays, shunts, pre-charge relays, internal copper bars for electrically connecting the above components, and mounting structures (mounting seats, mounting brackets, or the like) for connecting and assembling the above components.

Referring to FIG. 2 to FIG. 4, in some embodiments, the box body 410 has a mounting side surface 4102, the mounting side surface 4102 faces the case 10, and the through hole 411 is provided in the mounting side surface 4102.

The mounting side surface 4102 of the box body 410 refers to the end side surface of the box body 410 facing the case 10 when the box body 410 is connected to the case 10. It can be understood that when the box body 410 is connected to the case 10, a tight connection can be formed between the box body 410 and the case 10, so that the mounting side surface 4102 of the box body 410 abuts against the surface of the case 10; when the box body 410 is connected to the case 10, a spaced connection can be formed between the box body 410 and the case 10, so that a space is also formed between the mounting side surface 4102 of the box body 410 and the surface of the case 10.

The through hole 411 is provided in the mounting side surface 4102, so that the orifice of the through hole 411 faces the case 10 of the battery 100. Thereby, one end of the electrical connection structure 30 of the battery 100 can extend into the case 10 and be electrically connected to the battery cells 20, or form an electrical connection with the conductive connection portion of the battery cells 20 on the case 10, and the other end of the electrical connection structure 30 can extend to the through hole 411 provided in the mounting side surface 4102 and be inserted into the through hole 411, so that the electrical connection structure 30 can extend into the accommodation cavity 4101 and be directly electrically connected to the electrical components 420. The electrical connection structure 30 can be wired in a straight line, which, compared with the case where the through hole 411 is provided in other side surfaces of the box body 410, can effectively reduce the wiring distance of the electrical connection structure 30, thereby achieving the purpose of reducing the connection cost of the high-voltage box 400. At the same time, it is more convenient for the connection copper bars to be inserted into the through hole 411 along a straight line, thereby improving the assembly efficiency of the high-voltage box 400.

Referring to FIG. 2 to FIG. 4, in some embodiments, at least part of the mounting side surface 4102 abuts against the wall surface of the case 10, and the through hole 411 is provided in the part of the mounting side surface 4102 that abuts against the wall surface of the case 10.

At least part of the mounting side surface 4102 abuts against the wall surface of the case 10. Optionally, part of the mounting side surface 4102 abuts against the wall surface of the case 10, for example, part of the mounting side surface 4102 forms a protruding structure, and the protruding structure can abut against the wall surface of the case 10; or the mounting side surface 4102 can be an arc-shaped surface, so that part of the arc-shaped surface can abut against the wall surface of the case 10; or the mounting side surface 4102 can completely abut against the wall surface of the case 10, so that when the box body 410 is connected to the case 10, the mounting side surface 4102 of the box body 410 can overall abut against the wall surface of the case 10.

The through hole 411 is provided in the part of the mounting side surface 4102 that abuts against the wall surface of the case 10, so that when the box body 410 is connected to the case 10, the mounting side surface 4102 can abut against the case 10, and the wall surface of the case 10 can form a blockage for the through hole 411, effectively improving the sealing effect on the through hole 411, thereby improving the sealing protection effect on the inside of the accommodation cavity 4101. At the same time, since the mounting side surface 4102 abuts against the case 10, the distance between the orifice end of the through hole 411 and the case 10 can also be reduced, the wiring path of the electrical connection structure 30 from the case 10 to the through hole 411 and into the accommodation cavity 4101 is shorter, the material used for the electrical connection structure 30 is lower, and the connection material cost of the high-voltage box 400 can be reduced.

Referring to FIG. 2 to FIG. 4, in some embodiments, the high-voltage box 400 further includes a sealing structure 430, and the sealing structure 430 is provided on the box body 410 and configured to seal the through hole 411.

The sealing structure 430 is configured to seal the through hole 411, so that sealing and anti-slip can be achieved inside the accommodation cavity 4101, effectively reducing the probability of dust, water droplets, or the like entering the accommodation cavity 4101 from the through hole 411 and affecting the internal electrical components 420.

Optionally, in a first embodiment, the sealing structure 430 can be a sealant layer, and after the electrical connection structure 30 is inserted into the through hole 411 and the connection assembly is completed, the through hole 411 is sealed by a potting process to form a sealant layer.

Alternatively, in a second embodiment, the sealing structure 430 can be an elastic filling layer, such as a silicone filling layer or a rubber filling layer. The through hole 411 can be filled with the elastic filling layer, so that the gap between the hole inner wall of the through hole 411 and the connection copper bar is filled up with the elastic filling layer, thereby achieving sealing protection for the accommodation cavity 4101.

Alternatively, in a third embodiment, the sealing structure 430 can be an elastic sealing ring, such as a rubber sealing ring or a silicone sealing ring. The elastic sealing ring is provided on the mounting side surface 4102 and annularly provided around the orifice end of the through hole 411, so that when the box body 410 is mounted on the case 10, the mounting end side abuts against the wall surface of the case 10. In this way, the mounting end side and the wall surface of the case 10 clamp the elastic sealing ring, so that the elastic sealing ring can annularly seal the through hole 411.

In this way, by providing the sealing structure 430 on the box body 410, the through hole 411 provided in the box body 410 is sealed and protected by the sealing structure 430 to improve the sealing protection effect inside the accommodation cavity 4101.

Referring to FIG. 2 to FIG. 4, in some embodiments, the sealing structure 430 includes a sealing ring 431, the sealing ring 431 is clamped between the mounting side surface 4102 and the case 10, and the sealing ring 431 is annularly provided around the through hole 411.

The sealing ring 431 can be, but is not limited to, a silicone sealing ring 431, a rubber sealing ring 431, a foam sealing ring 431, and other annular sealing structures 430.

The sealing ring 431 is clamped between the mounting side surface 4102 and the case 10. Optionally, the sealing ring 431 can be adhered to the mounting side surface 4102, and the orifice end of the through hole 411 is located in the inner ring area of the sealing ring 431. Alternatively, a mounting ring groove surrounding the orifice end of the through hole 411 can be provided in the mounting side surface 4102, and the sealing ring 431 can be accommodated in the mounting ring groove to achieve assembly.

The number of sealing rings 431 can be one or more. When the number of sealing rings 431 is multiple, the sealing rings 431 can be sequentially sleeved to achieve multiple sealing protection for the through hole 411.

In this way, by providing the sealing ring 431 between the mounting side surface 4102 and the case 10, when the box body 410 is mounted on the case 10, the sealing ring 431 can be clamped between the mounting side surface 4102 and the case 10, so that the sealing ring 431 and the case 10 can provide sealing protection for the through hole 411, effectively improving the sealing of the accommodation cavity 4101.

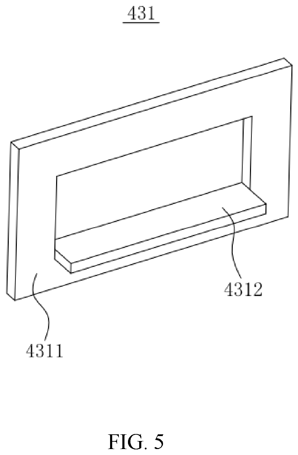

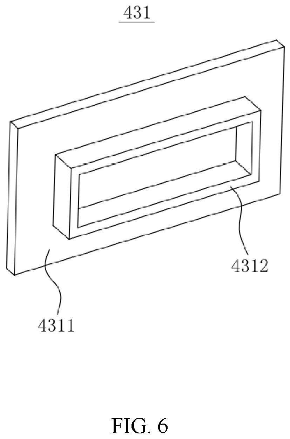

Referring to FIG. 2, FIG. 4 to FIG. 6, in some embodiments, the sealing ring 431 includes a main body portion 4311 and a protruding portion 4312, the main body portion 4311 is clamped between the mounting side surface 4102 and the case 10, the main body portion 4311 is annularly provided around the orifice end of the through hole 411, the protruding portion 4312 is connected to the main body portion 4311, and the protruding portion 4312 is inserted into the through hole 411.

It can be understood that the main body portion 4311 can be an annular structure, and the main body portion 4311 is configured to annularly surround the orifice end of the through hole 411 and is clamped between the mounting side surface 4102 and the case 10 to achieve sealing protection for the through hole 411.

The protruding portion 4312 is connected to the main body portion 4311. Optionally, the protruding portion 4312 can be adhered to the main body portion 4311, or the protruding portion 4312 and the main body portion 4311 can be integrally injection molded.

The protruding portion 4312 can be, but is not limited to, a protruding block, a protruding rod, a protruding plate, and a protruding ring; the protruding portion 4312 is inserted into the through hole 411, so that when the electrical connection structure 30 is inserted into the through hole 411, the protruding portion 4312 is located between the electrical connection structure 30 and at least one side wall surface of the hole inner wall of the through hole 411, and the protruding portion 4312 can separate the electrical connection structure 30 from the hole inner wall of the through hole 411, thereby reducing the probability that the insulation sleeve on the electrical connection structure 30 is worn by the orifice end or the hole inner wall of the through hole 411 during the process of inserting the electrical connection structure 30 into the through hole 411, and further reducing the risk of electric leakage in the electrical connection structure 30.

Exemplarily, in some specific embodiments, the main body portion 4311 can be an annular sealing rubber, and the protruding portion 4312 can be a rubber sheet integrally formed on the main body portion 4311. In the gravity direction, the rubber sheet is located below the inner ring of the main body portion 4311. Thereby, when the sealing ring 431 is assembled on the box body 410, the main body portion 4311 is adhered and fixed to the mounting side surface 4102, and the rubber sheet of the protruding portion 4312 extends into the through hole 411 and shields and protects the part of the hole inner wall of the through hole 411 located below in the gravity direction. In this way, during the process of inserting and assembling the electrical connection structure 30 into the through hole 411, the connection copper bar comes into contact neither with the hole inner wall of the through hole 411 nor with the edge formed between the hole inner wall of the through hole 411 and the mounting side surface 4102, thereby effectively reducing the probability that the insulation sleeve on the electrical connection structure 30 is worn by the orifice end or the hole inner wall of the through hole 411.

Referring to FIG. 2, FIG. 4, and FIG. 6, in some embodiments, the protruding portion 4312 is annular, and the protruding portion 4312 is located between the electrical connection structure 30 and a hole inner wall of the through hole 411.

It can be understood that the protruding portion 4312 is provided as an annular structure, so that when the main body portion 4311 is fixed on the mounting side surface 4102 of the box body 410, the protruding portion 4312 can be inserted into the through hole 411, and the annular protruding portion 4312 can protect the hole inner wall of the through hole 411 in the entire circumferential direction. In this way, during the process of inserting the electrical connection structure 30 into the through hole 411 for assembly, the electrical connection structure 30 does not contact the hole inner wall of the through hole 411 due to the annular protection of the protruding portion 4312; and the edge formed between the hole inner wall of the through hole 411 and the mounting side surface 4102 is also covered and protected by the protruding portion 4312 and the main body portion 4311 together, thereby effectively reducing the probability that the insulation sleeve on the electrical connection structure 30 is worn by the orifice end or the hole inner wall of the through hole 411.

Referring to FIG. 2, FIG. 4, and FIG. 6, in some embodiments, the protruding portion 4312 passes through the through hole 411 and extends into the accommodation cavity 4101.

It can be understood that since the protruding portion 4312 extends into the accommodation cavity 4101, the protruding portion 4312 can also cover and protect the orifice end of the through hole 411 on the side of the accommodation cavity 4101, and the edge formed by the connection between the hole inner wall of the through hole 411 and the inner side wall surface of the accommodation cavity 4101 can also be shielded by the protruding portion 4312. Thereby, during the process of inserting the electrical connection structure 30 into the through hole 411 for assembly, the probability that the connection copper bar contacts the edge formed by the connection between the hole inner wall of the through hole 411 and the inner side wall surface of the accommodation cavity 4101 is low, thereby reducing the probability that the insulation sleeve on the electrical connection structure 30 is worn or scratched by the orifice end on the side of the accommodation cavity 4101.

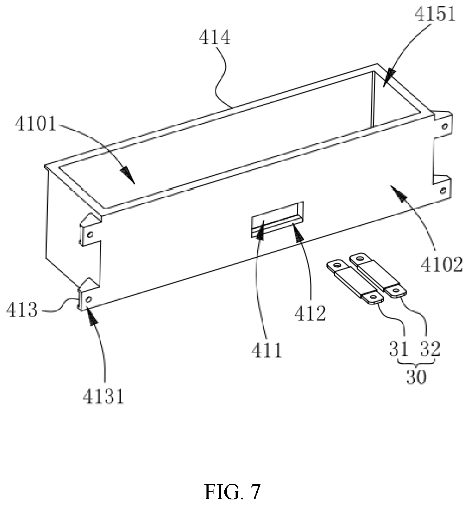

Referring to FIG. 7, in some embodiments, the mounting side surface 4102 and the hole inner wall of the through hole 411 are connected through a first chamfered surface 412.

The first chamfered surface 412 refers to an arc surface or an inclined surface formed by processing the edge formed through connection between the mounting side surface 4102 and the hole inner wall of the through hole 411.

In this way, the mounting side surface 4102 and the hole inner wall of the through hole 411 are connected through the first chamfered surface 412, and during the process of inserting the electrical connection structure 30 into the through hole 411 for assembly, the probability of scratching the insulation sleeve on the electrical connection structure 30 due to the formation of an edge between the mounting side surface 4102 and the hole inner wall of the through hole 411 can be reduced, thereby reducing the probability of electric leakage in the electrical connection structure 30.

Referring to FIG. 7, in some embodiments, the inner side wall surface of the accommodation cavity 4101 and the hole inner wall of the through hole 411 are connected through a second chamfered surface (not shown in the drawings).

In the inner side wall surface of the accommodation cavity 4101, the side wall surface that can directly connect to the hole inner wall of the through hole 411 is the inner side wall surface on the side where the through hole 411 is provided.

The second chamfered surface refers to an arc surface or an inclined surface formed by processing the edge formed through connection between the inner side wall surface of the accommodation cavity 4101 and the hole inner wall of the through hole 411.

In this way, the inner side wall surface of the accommodation cavity 4101 and the hole inner wall of the through hole 411 are connected through the second chamfered surface, and during the process of inserting the electrical connection structure 30 into the through hole 411 for assembly, the probability of scratching the insulation sleeve on the electrical connection structure 30 due to the formation of an edge between the inner side wall surface of the accommodation cavity 4101 and the hole inner wall of the through hole 411 can be reduced, thereby reducing the probability of electric leakage in the electrical connection structure 30.

Referring to FIG. 2 to FIG. 4, in some embodiments, a mounting portion 413 is provided on the box body 410, and the mounting portion 413 is connected to the case 10.

The mounting portion 413 is configured to connect to the case 10, so that the box body 410 is connected to the case 10 through the mounting portion 413.

Optionally, the mounting portion 413 includes but is not limited to structural parts such as a mounting bracket, a mounting plate, a mounting block, or a mounting beam. The number of mounting portions 413 can be one or more. The mounting portion 413 can achieve a fixed connection with the case 10 by screwing, snapping, welding, or the like.

The mounting portion 413 can be fixedly connected to the box body 410 by welding, screwing, snapping, integral molding, or the like. It can be understood that the mounting portion 413 can be provided at any position of the box body 410.

Exemplarily, in some specific embodiments, the mounting portion 413 can include a mounting block with a mounting hole provided. The number of mounting blocks can be multiple, for example, four, and the four mounting blocks are respectively formed on the end surfaces of the box body 410 intersecting the mounting side surface 4102. Fasteners (such as bolts or screws) pass through the mounting holes and are connected to the corresponding hole structures of the case 10 to achieve the purpose of fixing the box body 410 on the case 10 through the mounting blocks.

Referring to FIG. 2 to FIG. 4, in some embodiments, the mounting portion 413 has a connection surface 4131 facing the case 10, and the connection surface 4131 is flush with the mounting side surface 4102.

It can be understood that the connection surface 4131 refers to the end side surface of the mounting portion 413 facing the case 10 when the mounting portion 413 is connected to the case 10.

In this way, when the box body 410 is mounted on the case 10 through the mounting portion 413, the connection surface 4131 of the mounting portion 413 abuts against the case 10 and achieves fixed connection, so that the mounting side surface 4102 can synchronously abut against the surface mounted on the case 10 to ensure the abutting fit of the mounting side surface 4102 to the case 10, and the clamping effect on the sealing ring 431 between the mounting side surface 4102 and the case 10 is better, thereby improving the sealing protection effect of the sealing ring 431 on the through hole 411.

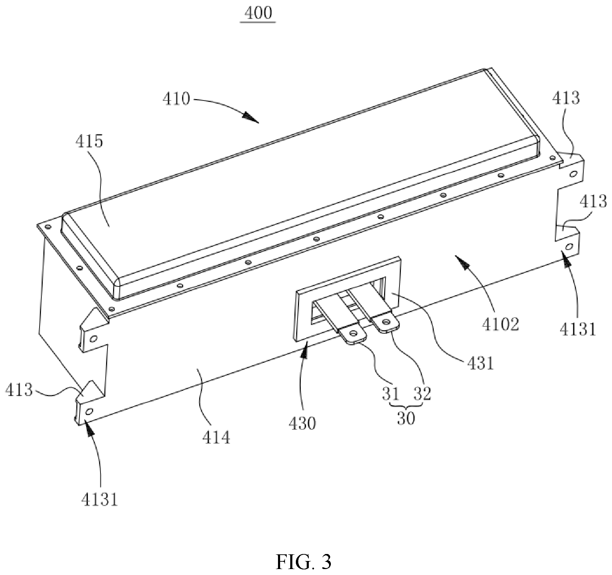

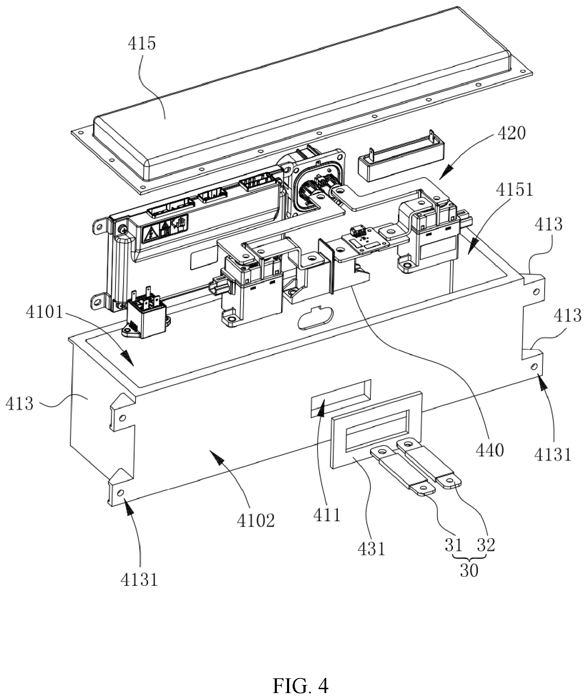

Referring to FIG. 3 and FIG. 4, in some embodiments, the box body 410 includes a housing 414 and an upper cover 415, the housing 414 forms the accommodation cavity 4101 with an opening 4151, and the upper cover 415 is connected to the housing 414 and covers the opening 4151; and the mounting portion 413 is provided on the housing 414, and the through hole 411 is provided in the housing 414.

The housing 414 forms the accommodation cavity 4101 with an opening 4151. Optionally, the housing 414 can be a hollow structure with an opening 4151 at one end, such as a rectangular housing with an opening 4151 at one end, a cylindrical housing with an opening 4151 at one end, or a spherical housing with an opening 4151 at one end.

The upper cover 415 is connected to the housing 414, so that the upper cover 415 serves as a sealing cover for the opening 4151, providing sealing protection for the accommodation cavity 4101. It can be understood that the upper cover 415 can be fixedly mounted on the housing 414 by fasteners, or the upper cover 415 can also be connected to the housing 414 by snapping.

The mounting portion 413 is provided on the housing 414, and the through hole 411 is provided in the housing 414. When maintenance of the high-voltage box 400 is required, the upper cover 415 can be opened to expose the electrical components 420 inside the accommodation cavity 4101 without removing the housing 414 from the case 10 and disassembling and assembling the housing 414 to open the accommodation, effectively improving the maintenance efficiency and convenience of maintenance.

Referring to FIG. 2 and FIG. 4, in some embodiments, a connection bracket 440 is provided in the accommodation cavity 4101, and the connection bracket 440 is configured to fixedly connect the electrical connection structure 30 and a conductive structure of the electrical components 420.

The connection bracket 440 can be, but is not limited to, an injection molded bracket, a rubber bracket, and other insulating support structures; the number of connection brackets 440 can be one or more. The connection bracket 440 can be fixed on the inner side surface of the accommodation cavity 4101 by screwing, adhesion, snapping, or the like.

It can be understood that the connection bracket 440 can be configured to fixedly connect the electrical connection structure 30 and the conductive structure (such as a copper bar structure) of the electrical components 420. For example, the electrical connection structure 30 and the conductive structure are lapped on the connection bracket 440, and then the electrical connection structure 30 and the conductive structure are fixed by bolts to achieve contact connection between the electrical connection structure 30 and the conductive structure. Alternatively, the connection bracket 440 can also be configured to support and fix the electrical components 420.

In this way, by providing the connection bracket 440 in the accommodation cavity 4101, the electrical connection structure 30 of the battery 100 and the conductive structure of the electrical components 420 can be fixed on the connection bracket 440 and achieve a contact connection, and the electrical connection is achieved through the fixing and contact connection method, effectively improving the stability and reliability of the electrical connection.

Referring to FIG. 2 to FIG. 4, in some embodiments, the number of through holes 411 is one or two.

When the number of through holes 411 is one, the electrical connection structure 30 can include connection copper bars, and the positive electrode copper bar 31 and the negative electrode copper bar 32 of the connection copper bars can both pass through the through hole 411 to electrically connect to the electrical components 420 inside the accommodation cavity 4101.

When the number of through holes 411 is two, the electrical connection structure 30 can include connection copper bars, and the positive electrode copper bar 31 and the negative electrode copper bar 32 of the connection copper bars can both pass through one of the through holes 411, so that the through hole 411 with a shorter required wiring path can be selected for use. Alternatively, the positive electrode copper bar 31 and the negative electrode copper bar 32 of the connection copper bars can respectively pass through different through holes 411, thereby reducing the size of the orifice of a single through hole 411, and further reducing the impact of the orifice being too large on the overall structural strength of the high-voltage box 400.

Exemplarily, in some specific embodiments, the high-voltage box 400 includes a box body 410, the box body 410 includes an upper cover 415 and a housing 414, the housing 414 forms an accommodation cavity 4101 with an opening 4151, and the upper cover 415 is connected to the housing 414 and covers the opening 4151. One side of the housing 414 facing the case 10 of the battery 100 is a mounting side surface 4102, a rectangular through hole 411 is provided in the mounting side surface 4102 of the housing 414, a sealing ring 431 is adhered on the mounting end side, and the sealing ring 431 is annularly provided around the through hole 411. Multiple mounting portions 413, such as mounting blocks, are integrally formed on the opposite end side surfaces of the housing 414 intersecting the mounting side surface 4102, the connection surface 4131 of the mounting blocks is flush with the mounting side surface 4102, and a mounting hole is provided in the mounting block.

During assembly, the housing 414 can be mounted on an outer surface of the case 10 through the mounting blocks, so that the electrical connection structure 30 can pass through the through hole 411 and extend into the accommodation cavity 4101 for contact connection with the conductive structure of the electrical components 420. Screws pass through the mounting holes of the mounting blocks and are tightened to the case 10. At this time, the connection surface 4131 of the mounting blocks and the mounting side surface 4102 flush with the connection surface 4131 abut against the outer side surface of the case 10, so that the mounting side surface 4102 and the case 10 clamp the sealing ring 431, and the sealing ring 431 can form sealing protection for the through hole 411 between the mounting side surface 4102 and the case 10.

Referring to FIG. 2 to FIG. 4, according to a second aspect, embodiments of this application further provide a battery 100 including a case 10, battery cells 20, an electrical connection structure 30, and the high-voltage box 400 as described above. The battery cells 20 are accommodated in the case 10, the box body 410 of the high-voltage box 400 is provided on the outer surface of the case 10, the electrical connection structure 30 is electrically connected to the battery cells 20, and the electrical connection structure 30 passes through the through hole 411 and is electrically connected to the electrical components 420 in the accommodation cavity 4101.

The battery 100 provided in the embodiments of this application includes the above high-voltage box 400. Since the box body 410 of the high-voltage box 400 is provided with a through hole 411, the electrical connection structure 30 of the battery 100 can pass through the through hole 411 and extend into the accommodation cavity 4101, so that the electrical connection structure 30 can be directly connected to the electrical components 420 in the accommodation cavity 4101, which can effectively reduce the probability of connection failure of the high-voltage box 400, thereby effectively improving the stability and reliability of the battery 100.

Referring to FIG. 1 and FIG. 2, according to a third aspect, embodiments of this application further provide an electric device including the battery 100 as described above, where the battery 100 is configured to provide electrical energy. The electric device can be any device or system that uses the battery 100 as described above, such as a vehicle 1000.

The electric device provided in the embodiments of this application includes the above battery 100, and on the basis that the above battery 100 has good stability and reliability, the electric device also has good stability and reliability.

The above are only preferred embodiments of this application and are not intended to limit this application. Any modifications, equivalent replacements, improvements, and the like made within the spirit and principles of this application shall be included in the protection scope of this application.

## Claims

1. A high-voltage box provided on a case of a battery, **characterized in that** the high-voltage box comprises a box body, the box body is connected to the case, an accommodation cavity for accommodating electrical components is formed inside the box body, the box body is provided with a through hole communicating with the accommodation cavity, and the through hole is used for insertion of an electrical connection structure of the battery.

2. The high-voltage box according to claim 1, **characterized in that** the box body has a mounting side surface, the mounting side surface faces the case, and the through hole is provided in the mounting side surface.

3. The high-voltage box according to claim 2, **characterized in that** at least part of the mounting side surface abuts against a wall surface of the case, and the through hole is provided in the part of the mounting side surface that abuts against the wall surface of the case.

4. The high-voltage box according to claim 2 or 3, **characterized in that** the high-voltage box further comprises a sealing structure, and the sealing structure is provided on the box body and configured to seal the through hole.

5. The high-voltage box according to claim 4, **characterized in that** the sealing structure comprises a sealing ring, the sealing ring is clamped between the mounting side surface and the case, and the sealing ring is annularly provided around an orifice end of the through hole.

6. The high-voltage box according to claim 5, **characterized in that** the sealing ring comprises a main body portion and a protruding portion, the main body portion is clamped between the mounting side surface and the case, the main body portion is annularly provided around the through hole, the protruding portion is connected to the main body portion, and the protruding portion is inserted into the through hole.

7. The high-voltage box according to claim 6, **characterized in that** the protruding portion is annular, and the protruding portion is located between the electrical connection structure and a hole inner wall of the through hole.

8. The high-voltage box according to claim 6 or 7, **characterized in that** the protruding portion passes through the through hole and extends into the accommodation cavity.

9. The high-voltage box according to any one of claims 2 to 8, **characterized in that** the mounting side surface and the hole inner wall of the through hole are connected through a first chamfered surface.

10. The high-voltage box according to claim 9, **characterized in that** an inner side wall surface of the accommodation cavity and the hole inner wall of the through hole are connected through a second chamfered surface.

11. The high-voltage box according to any one of claims 2 to 10, **characterized in that** a mounting portion is provided on the box body, and the mounting portion is connected to the case.

12. The high-voltage box according to claim 11, **characterized in that** the mounting portion has a connection surface facing the case, and the connection surface is flush with the mounting side surface.

13. The high-voltage box according to claim 11 or 12, **characterized in that** the box body comprises a housing and an upper cover, the housing forms the accommodation cavity with an opening, and the upper cover is connected to the housing and covers the opening; and the mounting portion is provided on the housing, and the through hole is provided in the housing.

14. The high-voltage box according to any one of claims 1 to 13, **characterized in that** a connection bracket is provided in the accommodation cavity, and the connection bracket is configured to fixedly connect the electrical connection structure and a conductive structure of the electrical components.

15. The high-voltage box according to any one of claims 1 to 14, **characterized in that** the number of the through holes is one or two.

16. A battery, **characterized by** comprising a case, battery cells, an electrical connection structure, and the high-voltage box according to any one of claims 1 to 15, wherein the battery cells are accommodated in the case, the box body of the high-voltage box is provided on an outer surface of the case, the electrical connection structure is electrically connected to the battery cells, and the electrical connection structure passes through the through hole and is electrically connected to the electrical components in the accommodation cavity.

17. An electric device, **characterized by** comprising the battery according to claim 16, wherein the battery is configured to provide electrical energy.
